# EUROPEAN PATENT APPLICATION

(11) **EP 0 810 298 A1**
(43) Date of publication of application: **03.12.1997**
(21) Application number: 96942562.8
(22) Date of filing: 18.12.1996
(51) Int. Cl.: C23C 10/22

(54) **THERMOPLASTIC RESIN MOLDING WITH METALLIC LAYER FORMED ON THE SURFACE THEREOF**

(30) Priority: 19.12.1995 JP 330216/95
(71) Applicant: POLYPLASTICS CO. LTD., Chuo-Ku Osaka-shi Osaka 541 (JP)
(72) Inventor: AKETA, Tomoyuki, Shizuoka 417 (JP)
(74) Representative: Jackson, Peter
(86) International application number: JP9603687
(87) International publication number: WO9722730

(57) **Abstract**

A resin molding with a metallic layer formed on the surface thereof, which has both fluidity high enough to be moldable into a thin molding and high rigidity and, in addition, possesses adhesion to plating sufficient for practical use. A resin molding prepared by molding a composite material comprising (a) 99 to 50 % by weight of a thermoplastic resin incapable of forming an anisotropic molten phase and (b) 1 to 50 % by weight of a liquid crystalline polyester capable of forming an anisotropic molten phase is pre-etched with an organic solvent followed by the formation of a metallic layer on the surface thereof by wet plating.

## Description

### Field of the Invention

The present invention relates to a molding obtained by molding a blended resin of a thermoplastic resin with a liquid crystal polyester resin and forming a metal layer thereon, more specifically to a resin molding having a good fluidity, a high rigidity and an excellent weld characteristic, wherein a thin wall molding suitable for automobiles, electrical appliances, office automation equipments, communication equipments and the like is obtained, and a metal layer capable of standing sufficiently well a practical use can be formed on the surface thereof by a conventional wet plating method.

### Description of the Related Art

A liquid crystal polyester is a thermoplastic resin having many characteristics such as a high strength, a high rigidity, a high heat resistance and a good moldability. However, it has the problems that since it has a low weld strength because of a specific molecular chain orientation, and a surface layer of the molding peels off, a sufficiently high plating adhesive strength can not be obtained simply by plating, and the plated product capable of standing a practical use can not be obtained by a simple process.

On the other hand, conventional thermoplastic resins have a relatively high weld strength and are less expensive than liquid crystal polyester but have the disadvantage that the physical properties such as a heat resistance and a rigidity are inferior to those of the liquid crystal polyester. In particular, because of a poor rigidity and fluidity for using them for thin wall housings, they can not help being increased in a wall thickness in designing, and therefore they have had the limits in meeting a trend of miniaturization and light weight of parts in the electrical, electronic and communication equipment fields in recent years.

### Summary of the Invention

In consideration of these problems, an object of the present invention is to provide a resin molding which can be molded with such a fluidity that a thin-wall molding can be formed sufficiently well and is endowed with a high rigidity and which has a metal layer formed on the surface thereof having a plating adhesive strength capable of standing a practical use.

In view of the problems described above, intensive searches and investigations made by the present inventors on a material which has excellent characteristics as a thin wall molding material and which facilitates surface metallization have resulted in finding out a resin composition which facilitates surface metallization as is the case with conventional thermoplastic resins and which provides the molding with high values of a mechanical strength, a heat resistance and a moldability which are close to those of a liquid crystal polyester, and thus coming to complete the present invention.

That is, the present invention provides a resin molding produced by molding a composite material comprising 99 to 50 % by weight of a thermoplastic resin (a) incapable of forming an anisotropic molten phase and 1 to 50 % by weight of a liquid crystal polyester (b) capable of forming an anisotropic molten phase, wherein the resin molding is pre-etched with an organic solvent, and then a metal layer is formed on the surface thereof according to a wet plating method.

### Detailed Description of the Invention

The present invention shall be explained below in detail.

The thermoplastic resin (a) incapable of forming an anisotropic molten phase used in the present invention includes, for example, polyolefin (co)polymers such as polyethylene, polypropylene and poly(4-methyl-1-pentene), polyester resins such as polyethylene terephthalate resins, polybutylene terephthalate resins and polycarbonate resins, polyamide resins, ABS resins, polyarylenesulfide resins, polyacrylates, polyacetals, and resins containing them as principal components. Among them, the polyester resins such as polycarbonate resins, polybutylene terephthalate resins and polyethylene terephthalate resins are preferred, and the polycarbonate resins having a relatively low molding shrinkage factor and linear expansion coefficient are particularly preferred.

The liquid crystal polyester (b) capable of forming an anisotropic molten phase used in the present invention has a molecular orientation in a molten state and shows an optical anisotropy. In this molecular orientation, the molecules are arranged in a major axis direction and a parallel direction thereof on the whole, and this axis may not necessarily be consistent with a gradient of the molecules. An anisotropy in a molten state can be observed by a conventional polarization inspecting method making use of an orthogonal polarizer. More specifically, the anisotropic molten phase can be confirmed by observing a molten sample put on a Leitz hot stage by means of a Leitz polarizing microscope at a magnification of 40 times under a nitrogen atmosphere. The polymers used in the present invention transmit polarized light even if it stands in a molten static state when it is inspected between the orthogonal polarizers to show an optical anisotropy.

This can be observed in the form of an optical pattern which is characteristic of a liquid crystal phase in some temperature range when gradual heating is applied. Further, a diffraction pattern which is characteristic of the phase can be observed as well in X-ray diffraction. In general, a differential scanning calorimeter is used in thermal analysis, and a change in entropy in various phase transitions and transition temperatures can be measured.

The liquid crystal polymer suited to use in the present invention tends to be substantially insoluble in conventional solvents and therefore is unsuitable for solution processing. As already described, however, these polymers can readily be processed by conventional melting processing methods.

Aromatic polyesters and aromatic polyesteramides are preferred as the polyester capable of forming an anisotropic molten phase used in the present invention, and polyesters containing partially aromatic polyesters and aromatic polyesteramides in the same molecular chain are preferred examples thereof as well.

Particularly preferably, it is a liquid crystal aromatic polyester or liquid crystal aromatic polyesteramide having as a structural component at least one compound selected from the group consisting of aromatic hydroxycarboxylic acids, aromatic hydroxylamines and aromatic diamines.

More specifically, included are:
1) polyester comprising principally at least one selected from aromatic hydroxycarboxylic acids and derivatives thereof,
2) polyester comprising principally:
   a) at least one selected from aromatic hydroxycarboxylic acids and derivatives thereof,
   b) at least one selected from aromatic dicarboxylic acids, alicyclic dicarboxylic acids, and derivatives thereof, and
   c) at least one selected from aromatic diols, alicyclic diols, aliphatic diols, and derivatives thereof,
3) polyesteramide comprising principally:
   a) at least one selected from aromatic hydroxycarboxylic acids and derivatives thereof,
   b) at least one selected from aromatic hydroxyamines, aromatic diamines, and derivatives thereof, and
   c) at least one selected from aromatic dicarboxylic acids, alicyclic dicarboxylic acids, and derivatives thereof, and
4) polyesteramide comprising principally:
   a) at least one selected from aromatic hydroxycarboxylic acids and derivatives thereof,
   b) at least one selected from aromatic hydroxyamines, aromatic diamines, and derivatives thereof,
   c) at least one selected from aromatic dicarboxylic acids, alicyclic dicarboxylic acids, and derivatives thereof, and
   d) at least one selected from aromatic diols, alicyclic diols, aliphatic diols, and derivatives thereof.

Further, a molecular weight-controlling agent may be used in combination with the structural components described above, if necessary.

Preferred examples of the specific compounds constituting the liquid crystal polyester used in the present invention include naphthalene compounds such as 2,6-naphthalenedicarboxylic acid, 2,6-dihydroxynaphthalene, 1,4-dihydroxynaphthalene, and 6-hydroxy-2-naphthoic acid, biphenyl compounds such as 4,4'-diphenyldicarboxylic acid and 4,4'-dihydroxybiphenyl, para-substituted benzene compounds such as p-hydroxybenzoic acid, terephthalic acid, hydroquinone, p-aminophenol, and p-phenylenediamine, and ring-substituted benzene compounds thereof (the substituents are selected from chlorine, bromine, methyl, phenyl, and 1-phenylethyl), and meta-substituted benzene compounds such as isophthalic acid and resorcin. Preferred examples of the specific compounds include naphthalene compounds such as 2,6-naphthalenedicarboxylic acid, 2,6-dihydroxynaphthalene, 1,4-dihydroxynaphthalene, and 6-hydroxy-2-naphthoic acid, biphenyl compounds such as 4,4'-diphenyldicarboxylic acid and 4,4'-dihydroxybiphenyl, and the compounds represented by the following formula (I), (II) or (III): 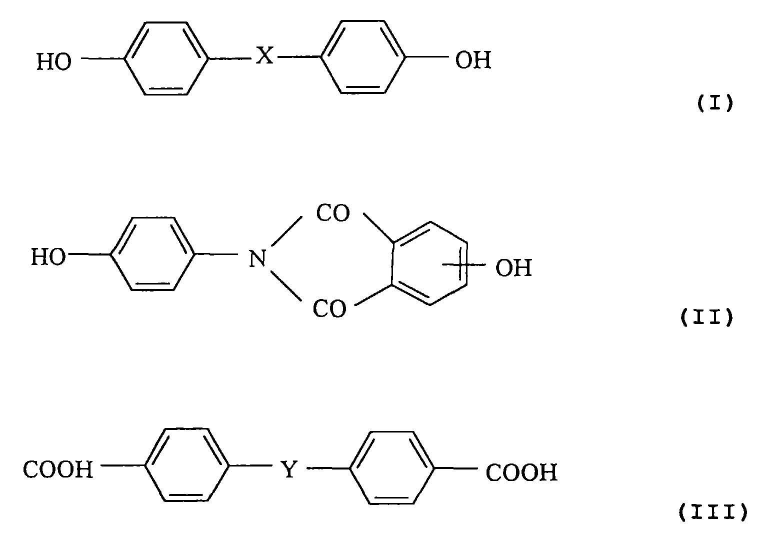 wherein X is a group selected from alkylene group of 1-4 carbon atoms, alkylidene group, -O-, -SO-, -SO₂-, -S-, and -CO-; and Y is a group selected from - (CH₂)ₙ- (n = 1 to 4) and
-O(CH₂)ₙO- (n = 1 to 4).

The liquid crystal polyester used in the present invention may contain partially polyalkylene terephthalate incapable of forming an anisotropic molten phase in the same molecular chain in addition to the structural components described above. In this case, the alkyl group has 2 to 4 carbon atoms.

The polyester containing as an essential component at least one selected from the naphthalene compounds, the biphenyl compounds and the para-substituted compounds out of the structural components described above is the further preferred example. Further, p-hydroxybenzoic acid, methylhydroquinone and 1-phenylethylhydroquinone out of the para-substituted benzene compounds are the particularly preferred examples.

Specific examples of a compound having an ester-forming functional group as the structural component and specific examples of the polyester capable of forming an anisotropic molten phase preferably used in the present invention are described in JP-B 63-36633.

In general, the aromatic polyesters and polyesteramides described above heve a logarithmic viscosity (I.V.) of at least about 2.0 dl/g, for example, about 2.0 to 10.0 dl/g when they are dissolved in an amount of 0.1 wt.% in pentafluorophenol at 60°C.

In the present invention, the resin molding comprises the thermoplastic resin (a) and the liquid crystal polyester (b) described previously, and the liquid crystal polyester is preferably micro-dispersed in the form of fibers having an aspect ratio of 6 or more in a matrix phase of the thermoplastic resin. This causes the liquid crystal polyester to play a role of a fiber-reinforcing material and makes it possible to reinforce the thermoplastic resin to provide a molding having a high rigidity. The term "fiberization" used here means that a fibrous or acicular structure is formed, and a fiber having a fibrous structure branched from a fiber-formed skeletal fiber is included if the skeletal fiber has an aspect ratio of 6 or more. The resin molding of the present invention can be obtained by kneading and injection-molding both by means of a conventional extruding machine. In the case where the liquid crystal polyester is more than the thermoplastic resin in terms of a composition proportion, the matrix phase may be reversed in some cases, and therefore the liquid crystal polyester falls preferably in a range of 1 to 50 % by weight based on 99 to 50 % by weight of the thermoplastic resin.

Further, the molding containing the fiber-formed liquid crystal polyester can be obtained as well by means of extrusion-molding including a drawing step for films and fibers.

The resin materials used in the present invention are preferably blended with silane compounds in order to plate them uniformly. The silane compound used in the present invention is at least one selected from vinylalkoxysilanes, aminoalkoxysilanes and mercaptoalkoxysilanes. Vinylalkoxysilanes include, for example, vinyltriethoxysilane, vinyltrimethoxysilane, and vinyltris(β-methoxyethoxy)silane; aminoalkoxysilanes include, for example, γ-aminopropyltriethoxysilane, γ-aminopropyltrimethoxysilane, γ-aminopropylmethyldiethoxysilane, γ-aminopropylmethyldimethoxysilane, N-(β-aminoethyl)-γ-aminopropyltrimethoxysilane, and N-phenyl-γ-aminopropyltrimethoxysilane; and mercaptoalkoxysilanes include, for example, γ-mercaptopropyltriethoxysilane and γ-mercaptopropyltrimethoxysilane.

A blend amount of these silane compounds is preferably 0.01 to 3.0 parts by weight, particularly preferably 0.05 to 0.5 part by weight per 100 parts by weight of the total of the thermoplastic resin (a) and the liquid crystal polyester (b). The amount of less than 0.01 part by weight makes the etched surface uneven depending on the molding conditions and sometimes brings about the disadvantage that the plating layer is swollen or peeled off. On the other hand, the amount exceeding 3.0 parts by weight brings about a reduction in an elastic modulus and a strength and therefore is not preferred.

Further, phosphorus compounds are preferably added in order to reveal an excellent fluidity in molding and obtain the molding having a high rigidity. In particular, in the case where the thermoplastic resin is a polycarbonate resin, the liquid crystal polyester is not dispersed in the form of islands in the polycarbonate resin and not fiber-formed even by injection-molding in some cases. In such cases, the effect of the phosphorus compounds shall be notably revealed. The phosphorus compounds include phosphides, phosphoric acid compounds and phosphorous acid compounds. The phosphorous acid compounds are preferred, and particularly preferred are pentaerythritol type phosphorous acid compounds such as bis(2,6-di-t-butyl-4-methylphenyl)pentaerythritol and bis(2,4,6-di-t-butylphenyl)pentaerythritol.

A blend amount of these phosphorus compounds is preferably 0.01 to 0.5 part by weight, particularly preferably 0.05 to 0.3 part by weight per 100 parts by weight of the total of the thermoplastic resin (a) and the liquid crystal polyester (b). In particular, the phosphorus compounds are blended preferably in an amount of 1 % by weight or more based on the weight of the liquid crystal polyester. The amount of less than 0.01 part by weight can not reveal the sufficiently high fluidity and rigidity, and the amount exceeding 0.5 part by weight generates a large quantity of gas of the phosphorus compounds added to rather result in damaging the mechanical strength and the moldability. Since the blend amount of the phosphorus compounds falling in the range described above facilitates very much the fiberization of the liquid crystal polyester and allows the fiberization to proceed regardless of the molding conditions and a form of the molding, it is preferred in terms of the rigidity.

Next, inorganic fillers are preferably blended in advance into the molding of the present invention. The inorganic filler is at least one finely divided inorganic filler selected from the group consisting of glass beads, glass balloon, glass powder, and oxides, sulfates, phosphates and silicates of elements belonging to the second group or twelfth group in the periodic table. In particular, at least one selected from the group consisting of oxides, sulfates, phosphates and silicates of the elements belonging to the second group or twelfth group in the periodic table is preferred.

The oxides of the elements belonging to the second group or twelfth group in the periodic table are compounds such as magnesium oxide, calcium oxide, barium oxide, and zinc oxide; the phosphates are compounds such as magnesium phosphate, barium phosphate, zinc phosphate, magnesium pyrophosphate, and calcium pyrophosphate; the sulfates are compounds such as magnesium sulfate, calcium sulfate, and barium sulfate; the silicates are compounds such as magnesium silicate, calcium silicate, talc, and wollastonite; and the carbonates are compounds such as calcium carbonate, magnesium carbonate, barium carbonate, and zinc carbonate.

These inorganic fillers are preferably used in a surface treating method applied when the molding is treated with an acid or an alkali (etching treatment) particularly before subjecting it to a surface metal treatment. The phosphates are particularly suitable.

A particle diameter of the inorganic fillers falls in a rage 0.01 to 100 µm, preferably 0.1 to 30 µm, and more preferably 0.5 to 10 µm in terms of an average particle diameter. The particle diameter of less than 0.01 µm is liable to form coagulated lumps on the surface of the molding due to inferior dispersion, and the particle diameter exceeding 100 µm increases a roughness of the surface after etching and therefore can not provide the good appearance.

Further, fibrous inorganic matters are preferred as the inorganic fillers and used alone or in combination with the finely divided inorganic fillers described above.

The fibrous fillers include fibrous inorganic substances such as glass fibers, milled glass fibers, carbon fibers, asbestos fibers, silica fibers, silica·alumina fibers, alumina fibers, zirconia fibers, boron nitride fibers, silicon nitride fibers, boron fibers, potassium titanate fibers, and fibrous matters of metals including stainless steel, aluminum, titanium, copper, and brass. Glass fibers and milled glass fibers are particularly preferred.

With respect to the form of these fibrous inorganic matters, the diameter falls preferably in a range of 0.1 to 30 µm, and the average length falls preferably in a range of 5 µm to 1 mm, particularly preferably 10 to 300 µm.

The inorganic fillers used in the present invention can be used in combination with publicly known surface treating agents according to the required physical properties. The examples thereof include functional compounds such as epoxy compounds, isocyanate compounds, titanate compounds, and silane compounds. The inorganic fillers treated with compounds such as epoxy compounds and polyamide compounds other than amino compounds are preferred.

These fillers may be used after subjecting them in advance to a surface treatment, or they may be added at the same time in preparing the material.

A blend amount of these inorganic fillers is 1 to 200 parts by weight, preferably 20 to 100 parts by weight based on 100 parts by weight of the total of the thermoplastic resin (a) and the liquid crystal polyester (b). The amount exceeding 200 parts by weight reduces a fluidity of the resin and does not provide the molding having a good surface. In addition thereto, it deteriorates as well a mechanical strength of the molding and therefore is not preferred. It is not preferred in terms of the molding processability and the various physical properties that the total blend amount of the preceding finely divided inorganic fillers and fibrous inorganic matters exceeds 200 parts by weight.

Next, the molding of the present invention can be obtained by subjecting the molding comprising the resin composition described above to a surface metal treatment. The surface metal treatment is a wet surface treating method using a solution. More specifically, it comprises the steps of etching the molding with an acid aqueous solution to provide it with an adhesion-accelerating property between metal and the resin by an anchor effect and a hydrophilicity given to the resin and then forming a metal layer on the surface of the resin molding by electroless plating or electroplating.

Pre-etching with an organic solvent before the etching treatment with an acid aqueous solution is preferred in terms of causing an etching solution used in the following step to work more effectively. The pre-etching applied here is to immerse the molding with a mixed solution containing at least one selected from alcohols, ketones such as acetone, formamides such as dimethylforamide, aldehydes such as formaldehyde, sulfoxides such as dimethylsulfoxide, and amines such as dimethylamine, or a mixed solution of the above solution and water. This pre-etching swells the surface of the molding or produces fine cracks thereon to enable the following etching treatment with an acid aqueous solution to be carried out readily and effectively. In this case, water is preferably mixed in order to prevent the rapid pre-etching, and therefore the organic solvents miscible uniformly with water are particularly preferred.

Next, in the etching with an acid aqueous solution, an etching treatment is carried out preferably with an acid solution of hydrochloric acid, sulfuric acid, oxalic acid, or chromic acid/sulfuric acid. In this case, the preferred conditions are such that the etching treatment is carried out with at least one of hydrochloric acid, sulfuric acid or oxalic acid of 3 to 35 %, and a mixed solution of 100 to 800 g/liter of sulfuric acid and 15 g or more of chromic anhydride at 30 to 70°C for 2 to 30 minutes.

In general, treatment called conditioning or wetting is carried out after the etching treatment. In this case, conventional and commercial solutions can be used. Specific examples thereof include Cindilizer SP (manufactured by Okuno Seiyaku Kougyou Co., Ltd.) and Cleaner/Conditioner 1110 (manufactured by Shipley Far East Co., Ltd.). After finishing these treatments, the molding can be treated by a conventional step for plating resins which is similar to a plating step for an ABS resin and the like. That is, the steps of catalytic treatment, activating treatment and electroless plating are carried out, and electroplating further follows if necessary.

A plating step for a flat plate was carried out in the following manner in the examples:
(1) the molding was degreased by Ace Clean A-220 (brand name) manufactured by Okuno Seiyaku Kougyou Co., Ltd. at 60°C for 5 minutes and washed in water, then
(2) pre-etching was carried out with a solution described in the table at 45°C for 5 minutes, and this was washed in water,
(3) etching was carried out in the conditions described in the table, and this was subjected to ultrasonic cleaning in water,
(4) conditioning was carried out by means of a cleaner in Conditioner 1110A (brand name) manufactured by Shipley Far East Co., Ltd. at room temperatures for 3 minutes, and washing in water was carried out, then
(5) catalytic treatment was carried out in Cataposit 44 (brand name) manufactured by Meltex Co., Ltd. at 43°C for 3 minutes, and washing in water was carried out,
(6) activation was carried out in Accelerator 241 (brand name)) manufactured by Shipley Far East Co., Ltd. at 30°c for 2 minutes, and washing in water was carried out,
(7) electroless copper plating was carried out in Cuposit 250 (brand name)) manufactured by Shipley Far East Co., Ltd. at 45°c for 20 minutes, and washing in water was carried out,
(8) activation by acid was carried out in a 5 % sulfuric acid aqueous solution at room temperatures for 30 seconds, and then
(9) electrolytic copper plating was carried out in a copper sulfate bath for a multilayer wiring plate using Copper Gream 125 (brand name) manufactured by Meltex Co., Ltd. as a brightening agent at 3.5 A/dm² for one hour.

### Examples

The present invention shall more specifically be described below with reference to examples, but the present invention shall not be restricted thereto.

### Examples 1 to 7

Resin compositions each comprising a polycarbonate resin (Eupiron H3000 manufactured by Mitsubishi Gas Chemical Co., Ltd.), a liquid crystal polyester resin (LCP) (Vectra A950 manufactured by Polyplastics Co., Ltd.), a silane compound (γ-aminopropyltriethoxysilane), phosphite [bis(2,6-di-t-butyl-4-methylphenyl)pentaerythritol-diphosphite], and an inorganic filler in the amounts shown in Table 1 were prepared and molten and kneaded by means of a two-shaft extruding machine of 30 mm at a resin temperature of 300°C, followed by pelletizing them. Then, the pellets were molded into test pieces by means of an injection-molding machine at a molding temperature (showing a cylinder-setting temperature) of 300°C to determine a melt viscosity, an Izod impact strength, a weld strength and a flexural elastic modulus. Further, flat plates (120 × 120 × 2 mm) molded from them were subjected to plating by various etchings to evaluate a surface condition, an adhesive strength and a humidity and heat resistance, after drying (at 85°C for one hour) treatment. The results thereof are shown in Table 1.

### Comparative Examples 1 to 4

In two cases of presence and absence of the inorganic filler in a system of the polycarbonate resin and LCP, the plating properties observed when pre-etching was not carried out and the plating properties observed when the silane compound was not used were evaluated in the same manner as that in the examples described above. The results thereof are shown in Table 1.

### Example 8

A molding was prepared and evaluated in the same manners as those in the other examples, except that a polybutylene terephthalate resin (Dx 2000 manufactured by Polyplastics Co., Ltd.) was substituted for the polycarbonate resin and that the resin temperature in extrusion was changed to 290°C and the molding temperature was changed to 270°C. The results thereof are shown in Table 1.

Evaluations in the examples were carried out in the following conditions.

### [Flexural elastic modulus and Izod impact strength]

The flexural elastic modulus and the Izod impact strength were measured according to ASTM D 790 and ASTM D 256, respectively.

### [Melt viscosity]

The melt viscosity was determined by means of a capillograph manufactured by Toyo Seimitsu Co., Ltd. using a capillary of φ 1 × 10L at 300°C when the matrix was the polycarbonate resin and 270°C when the matrix was the polybutylene terephthalate resin at a shear rate of 1200 sec⁻¹.

### [Weld strength]

The weld strength was evaluated by using a dumbbell specimen which was molded at two-point gates from both ends of the molding to form a weld in a central part and determining a tensile strength in a weld part.

### [Average aspect ratio (length/thickness) of LCP]

After the test piece used for determining the flexural elastic modulus was cut so that a face parallel to a flow direction was formed, the cross section thereof was subjected to mirror polishing, and the surface thereof was observed under an electron microscope to evaluate the average aspect ratio. That is, length/thickness ratios of 50 pieces of fiber-formed LCP optionally selected were determined to obtain the average value. With respect to the length, the lengths capable of being observed on the surface were measured. The evaluation criteria were set as follows:
- ○:: average aspect ratio of 6 or more
- X:: average aspect ratio of less than 6

### [Plating property]

A plated flat plate (120 × 120 × 2 mm) was put in a blast drier at 85°C for one hour, and after taking it out, it was left for standing up to room temperatures to evaluate blisters observed on the plated surface. Then, an adhesive strength test was carried out according to a test method JIS C 6481 (peeling strength) for a printed wiring plate.

The plated flat plate (120 × 120 × 2 mm) was put in a constant humidity and constant temperature chamber and left for standing at 85°C and 85 % RH for 96 hours. Then, a moisture and heat resistance was evaluated by inspecting blisters on the plated surface.

The flat plate used for plating was molded using a die having a gate size of 2 × 5 mm at a cylinder temperature of 300°C when the matrix was a polycarbonate resin and 270°C when the matrix was a polybutylene terephthalate resin.

Blisters on the plated surface were evaluated according to the following criteria:
- ○:: no blisters found
- △:: some blisters found in the vicinity of the gate
- X:: many blisters found

The flat plates used in the respective examples described above were plated in the steps shown above.

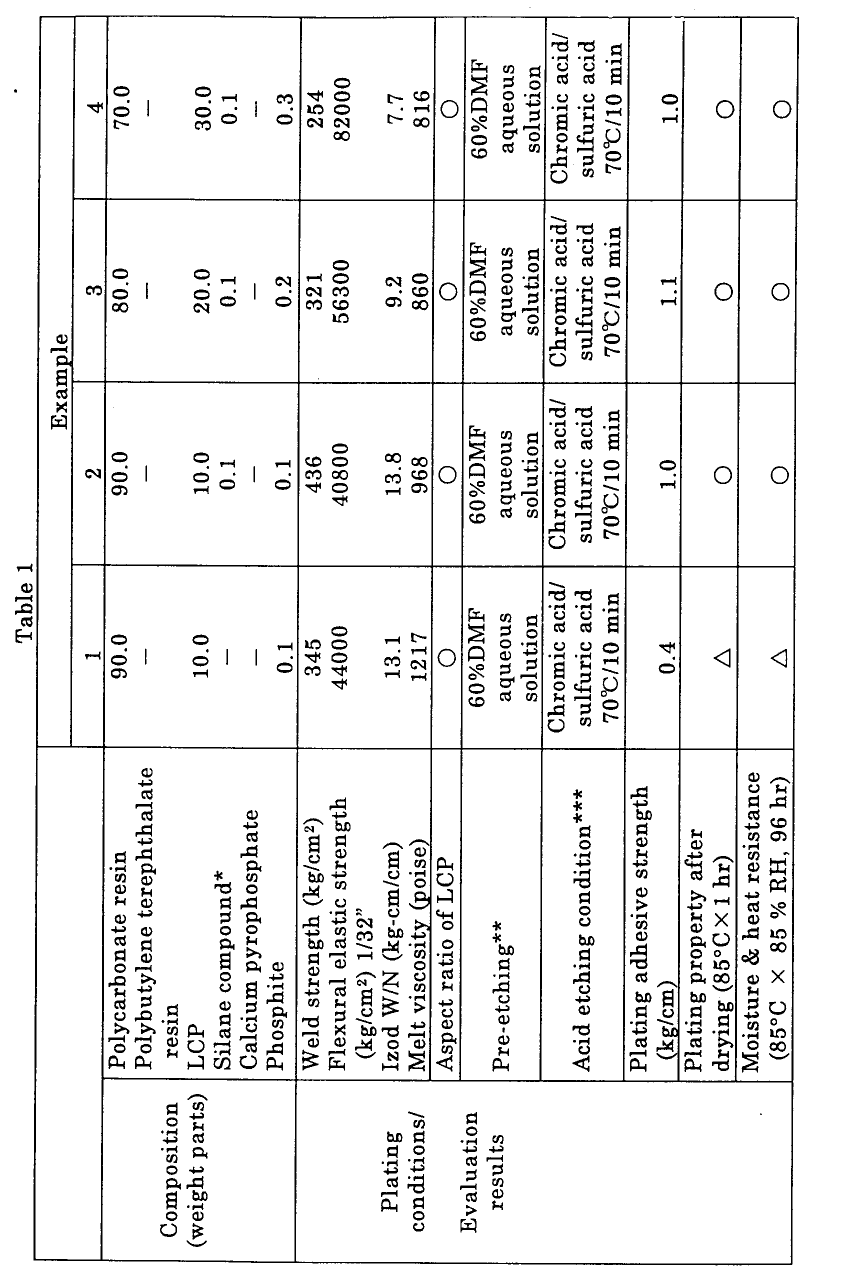

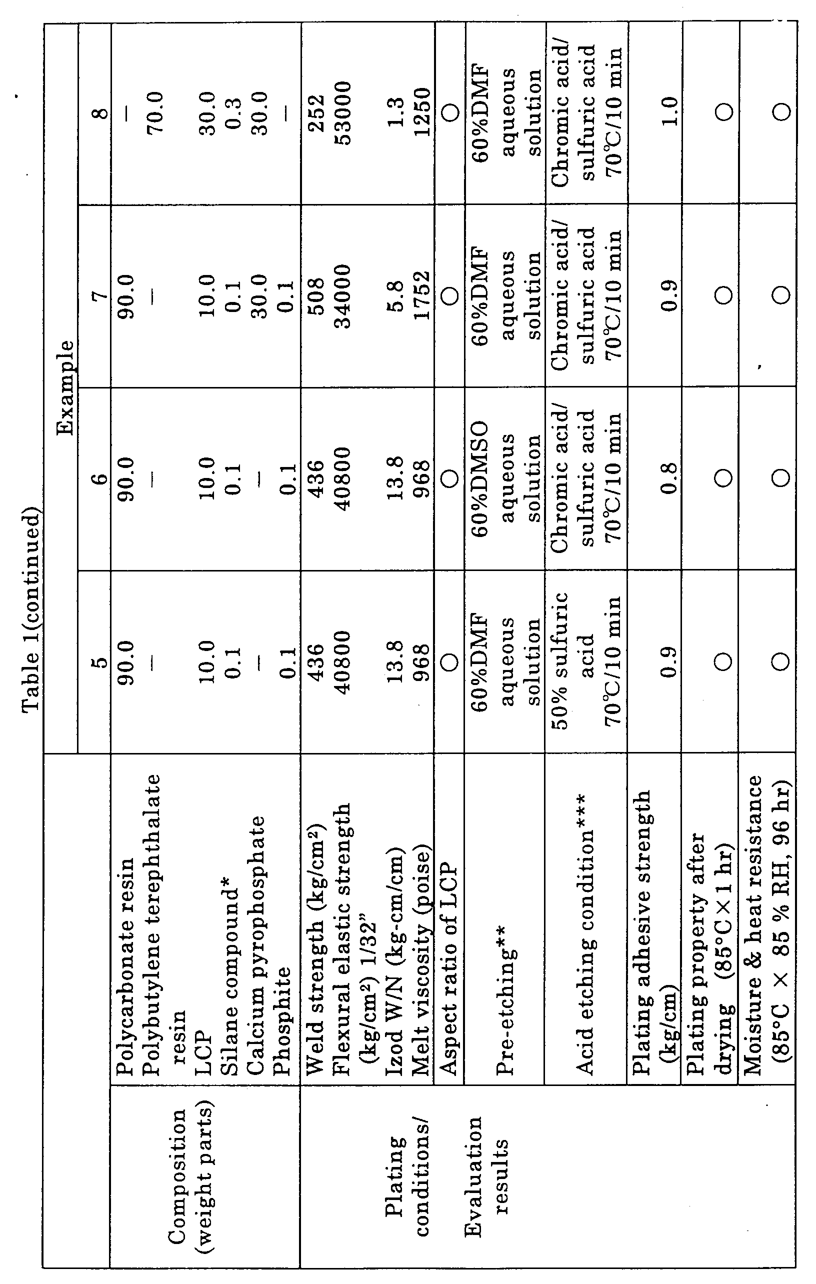

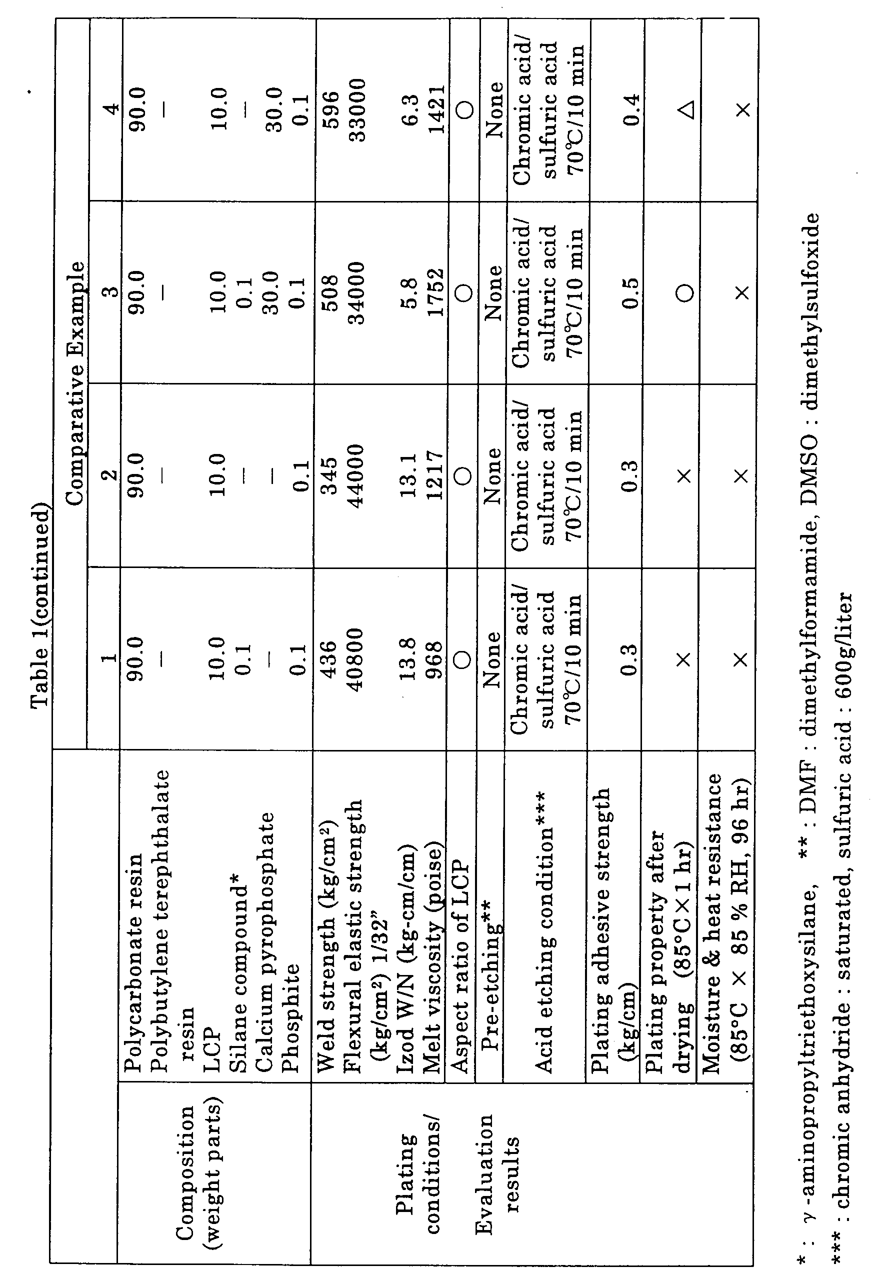

## Claims

1. A resin molding produced by molding a composite material comprising 99 to 50 wt. % of a thermoplastic resin (a) incapable of forming an anisotropic molten phase and 1 to 50 wt. % of a liquid crystal polyester (b) capable of forming an anisotropic molten phase, pre-etching the resulting resin molding with an organic solvent, and then forming a metal layer on the surface thereof according to a wet plating method.

2. The resin molding as claimed in Claim 1, produced by molding said composite material further blended with a silane compound in an amount of 0.01 to 3.0 parts by weight per 100 parts by weight in total of said thermoplastic resin (a) and said liquid crystal polyester (b), pre-etching the resulting resin molding with an organic solvent, and then forming a metal layer on the surface thereof according to a wet plating method.

3. The resin molding having a metal layer formed on the surface thereof as claimed in Claim 1 or 2, characterized in that said liquid crystal polyester (b) exists in the form of a fiber having an aspect ratio of at least 6 in said thermoplastic resin (a) incapable of forming an anisotropic molten phase as the matrix.

4. The resin molding having a metal layer formed on the surface thereof as claimed in any one of Claims 1 to 3, characterized in that said thermoplastic resin (a) is a polyester resin.

5. The resin molding having a metal layer formed on the surface thereof as claimed in Claim 4, characterized in that said thermoplastic resin (a) is a polycarbonate resin.

6. The resin molding as claimed in Claim 5, produced by molding said composite material further blended with a phosphorus compound in an amount of 0.01 to 0.5 part by weight per 100 parts by weight in total of said polycarbonate resin (a) and said liquid crystal polyester (b), pre-etching the resulting resin molding with an organic solvent, and then forming a metal layer on the surface thereof according to a wet plating method.

7. The resin molding as claimed in any one of Claims 1 to 6, produced by molding said composite material further blended with an inorganic filler in an amount of 1 to 200 parts by weight per 100 parts by weight in total of said thermoplastic resin (a) and said liquid crystal polyester (b), pre-etching the resulting resin molding with an organic solvent, and then forming a metal layer on the surface thereof according to a wet plating method.

8. The resin molding having a metal layer formed on the surface thereof as claimed in Claim 7, characterized in that said inorganic filler is at least one finely divided inorganic filler selected from the group consisting of oxides, sulfates, phosphates, and silicates of elements belonging to the group 2 or 12 in the periodic table, and elements and oxides of aluminum, silicon, tin, lead, antimony, and bismuth.

9. The resin molding having a metal layer formed on the surface thereof as claimed in Claim 7, wherein said inorganic filler is calcium pyrophosphate.

10. The resin molding having a metal layer formed on the surface thereof as claimed in any one of Claims 1 to 9, characterized in that said wet plating method comprises ething the surface of said resin molding with an aqueous acid solution, after pre-etching the same with an organic solvent, followed by electroless plating or electroplating.

11. The resin molding having a metal layer formed on the surface thereof as claimed in Claim 10, characterized in that said organic solvent is a member or a mixture of at least two members selected from among alcohols, ketones, formamides, aldehydes, sulfoxides, and amines, or a mixture thereof with water.

12. The resin molding having a metal layer formed on the surface thereof as claimed in Claim 10 or 11, characterized in that said aqueous acid solution is an aqueous solution of an inorganic acid or an organic acid, or a mixture of said aqueous solution with an alcohol.

13. The resin molding having a metal layer formed on the surface thereof as claimed in any one of Claims 1 to 12, which is a structure in the form of a housing, a connector, a CD pickup part, or a digital disk machinery part.

14. The resin molding having a metal layer formed on the surface thereof as claimed in any one of Claims 1 to 12, which is a film, a sheet, or a fiber.
